# EUROPÄISCHE PATENTANMELDUNG

(11) **EP 1 087 481 A1**
(43) Veröffentlichungstag der Anmeldung: **28.03.2001**
(21) Anmeldenummer: 00250322.5
(22) Anmeldetag: 27.09.2000
(51) Int. Cl.: H02B 1/06

(54) **Gehäuse, insbesondere für den Einbau elektrischer und elektronischer Bauteile**

(30) Priorität: 27.09.1999 DE 19946241
(71) Anmelder: Rolec Gehäuse-Systeme GmbH, 31737 Rinteln (DE)
(72) Erfinder: Rose, Friedhelm, 32457 Porta Westfalica (DE)
(74) Vertreter: Seewald, Jürgen, Dipl.-Ing.

(57) **Zusammenfassung**

Die vorliegende Erfindung betrifft ein Gehäuse, insbesondere für den Einbau elektrischer und elektronischer Bauteile, bestehend aus einem Gehäuse-Unterteil und einem daran befestigbaren Deckel. Das Gehäuse-Unterteil weist wenigstens auf einer Seite mindestens zwei von seiner Schließfläche bis zu seinem Boden durchgehende Befestigungskanäle auf, und Deckel und Gehäuse-Unterteil sind über flexible Innenelemente scharnierartig miteinander verbunden. Diese flexiblen Elemente (15) werden unabhängig von der Befestigung des Deckels (3) an denselben und in das Gehäuse-Unterteil (2) eingebunden. Dazu werden die ohnehin vorhandenen Befestigungskanäle (10) sowie im Deckel (3) vorgesehene Gewinde-Sackbohrungen (13,14) genutzt. In diese werden Gewindebuchsen (17,16) eingeschraubt, die über das flexible Element (15) verbunden sind.

## Beschreibung

Die vorliegende Erfindung betrifft ein Gehäuse, insbesondere für den Einbau elektrischer und elektronischer Bauteile, bestehend aus einem Gehäuse-Unterteil und einem daran befestigbaren Deckel gemäß dem Oberbegriff des Anspruchs 1.

Handelsübliche Gehäuse, vorwiegend aus Aluminium aber auch aus glasfaserverstärktem Polyester oder aus thermoplastischem Kunststoff, haben im Gehäuse-Unterteil in den Eckbereichen jeweils eine Gewindebohrung für die Befestigung eines Deckels, der dazu mit Durchgangsbohrungen mit einer Senkung für den Schraubenkopf versehen ist. Aus Material- und Gewichtsersparnis-Gründen schließt sich an die Gewindebohrungen axial mit diesen fluchtend ein bis auf die Unterteil-Unterseite durchgehender Kanal an, dessen lichte Weite größer als der Durchmesser der Gewindebohrung ist. Parallel zu diesen Kanälen und in der Regel unmittelbar daneben verläuft jeweils ein Befestigungskanal von der Unterteil-Oberseite bis zur Unterteil-Unterseite durch. Dieser Kanal dient der Befestigung des Unterteils an einer Unterlage. Er ist an seinem unteren Ende auf eine geringere lichte Weite abgestuft, so daß sich ein Auflagebund für einen Schraubenkopf ergibt.

Es besteht bei Gehäuseanwendern oft der Wunsch, Gehäuse-Unterteil und Deckel in einer Weise miteinander zu verbinden, daß eine Art Deckelgelenk entsteht. Im Gehäuse-Unterteil und im Deckel werden häufig elektrotechnische und/oder elektronische Komponenten montiert, die durch Kabel oder Leiterbahnen miteinander verbunden sind. Es ist wichtig, daß diese Verbindungen bei geöffneten Deckeln nicht durch Zug belastet werden. Aus verschiedenen Gründen bevorzugen Gehäuseanwender dabei innenliegende Deckelgelenke, also Gelenke, die bei geschlossenem Deckel nach außen nicht sichtbar sind.

Ein in DE 92 16 735 U1 offenbartes Drahtseil-Scharnier erfüllt diese Forderungen. Dieses Scharnier besteht aus einem Drahtseilstück, dessen eines Ende in eine Deckelschraube eingewalzt ist. Diese Deckelschraube weist dazu an ihrem kopffernen Ende eine axiale Sackbohrung auf, in die das Seilstück vor dem Einwalzen eingesteckt wird. Auf das andere Drahtseilende ist in gleicher Weise ein Gewindestift aufgewalzt, dessen GewindeDurchmesser dem der Deckelschraube entspricht. Damit sind die Deckelschraube und der Gewindestift drehfest mit dem Drahtseilstück verbunden. Zur Montage des Scharniers wird, das Ende mit dem Gewindestift durch die Deckelbohrung hindurchgesteckt und dann durch die für die Deckelschraube bestimmte Gewindebohrung im Gehäuse-Unterteil hindurchgeschraubt. Da sich die Gewindebohrung, wie weiter oben schon ausgeführt wurde, nach unten hin zu einem Kanal erweitert, fällt das Drahtseil-Scharnier insgesamt nach unten in den Kanal, bis die Deckelschraube mit ihrem unteren Ende auf dem Gehäuse-Unterteil aufliegt. Ein Zurückziehen des Drahtseil-Scharniers ist nun nur noch so weit möglich, bis das obere Ende des Gewindestiftes am unteren Ende der Gewindebohrung anliegt. Die Deckelschraube kann nun in die Gewindebohrung des Gehäuse-Unterteils eingeschraubt werden. Dieser Montagevorgang wird an der anderen Ecke der gleichen Gehäuseseite wiederholt. Nun können auch die anderen Deckelschrauben eingeschraubt werden.

Zum Öffnen des Deckels werden alle Deckelschrauben, auch die in das Drahtseil-Scharnier integrierten, aus den Gewindebohrungen des Gehäuse-Unterteils herausgeschraubt. Der Deckel kann nun um seine Scharnierseite herumgeklappt werden. Dabei werden die Drahtseile aus den Kanälen so weit herausgezogen, bis die Oberseiten der Gewindestifte von unten an die Gewindebohrung anstoßen. Die Gewindestifte wirken somit im Zusammenspiel mit der Unterseite der Gewindebohrung als Stopper. Die Länge der Drahtseilstücke ist dabei so bemessen, daß der gewünschte Schwenkwinkel des Deckels erreicht wird. Auf seiner Außenseite wird der Deckel durch die Deckelschrauben des Drahtseil-Scharniers gehalten, die in den Deckelbohrungen sitzen.

In der Praxis hat sich gezeigt, daß diese bekannten Drahtseil-Scharniere störanfällig sind, da die Einwalzungen der Drahtseilenden nicht immer sicher halten. Zudem ist dieses Scharnier relativ aufwendig in seiner Herstellung.

Ein weiterer Nachteil ist darin zu sehen, daß die Drahtseil-Scharniere bei den Gehäuse-Herstellern mit unterschiedlichen Schraubenköpfen - Schlitz-, Imbus-Kopf etc. - je nach den Wünschen des Kunden, bereitgehalten werden müssen. Der Lagerhaltungs-Aufwand wird darüber hinaus dadurch noch weiter erhöht, daß für unterschiedliche Deckelhöhen auch unterschiedlich lange Deckelschrauben erforderlich sind.

Aufgabe der vorliegenden Erfindung ist es daher, ein gattungsgemäßes Gehäuse zur Verfügung zu stellen, welches die oben genannten Nachteile nicht aufweist.

Diese Aufgabe wird erfindungsgemäß durch ein Gehäuse mit den Merkmalen des Anspruchs 1 gelöst.

Die erfindungsgemäße Anbindung des flexiblen Scharnierelements an Deckel und Gehäuse-Unterteil ist vollständig unabhängig von der Deckelverschraubung, so daß die in diesem Zusammenhang erläuterten Nachteile des Standes der Technik eliminiert sind. Auch läßt sich das flexible Scharnierelement relativ einfach herstellen und montieren. Zur Montage werden u.a die ohnehin schon vorgesehenen Befestigungskanäle genutzt, die nur noch mit einem Gewinde zu versehen sind. Zusätzlich sind lediglich Gewinde-Sackbohrungen im Deckel vorzusehen.

Ein weiterer Vorteil der erfindungsgemäßen Lösung ist darin zu sehen, daß das flexible Scharnierelement bei Bedarf von den Gehäuseanwendern ohne großen Aufwand gekürzt werden kann.

In weiterer Ausgestaltung der Erfindung ist zumindest eine der Verdickungen an den Enden des flexiblen Elements durch ein aufschiebbares und auf das flexible Element festschraubbares Klemmstück gebildet. Die andere Verdickung kann schon bei der Herstellung des flexiblen Elements, z.B. wenn dieses aus Kunststoff besteht, durch Anspritzen gebildet werden.

In einer bevorzugten Ausführungsform der Erfindung ist das flexible Element ein Drahtseil.

Die Erfindung wird nachstehend anhand eines Ausführungsbeispiels näher erläutert. In der dazugehörigen Zeichnung zeigt:
- Fig. 1: eine Ansicht eines für ein flexibles Scharnier eingesetzten Drahtseilstücks mit an seinen Enden aufgeschraubten Klemmstücken, die im Schnitt dargestellt sind,
- Fig. 1.1: ein einzelnes Klemmstück im Schnitt,
- Fig. 2: einen Schnitt durch eine Gehäuseecke bei montiertem, flexiblem Scharnier und auf das Gehäuse-Unterteil aufgeschraubtem Deckel, und
- Fig. 3: eine Darstellung gemäß Fig. 1 um 90° gedreht bei geöffnetem Deckel.

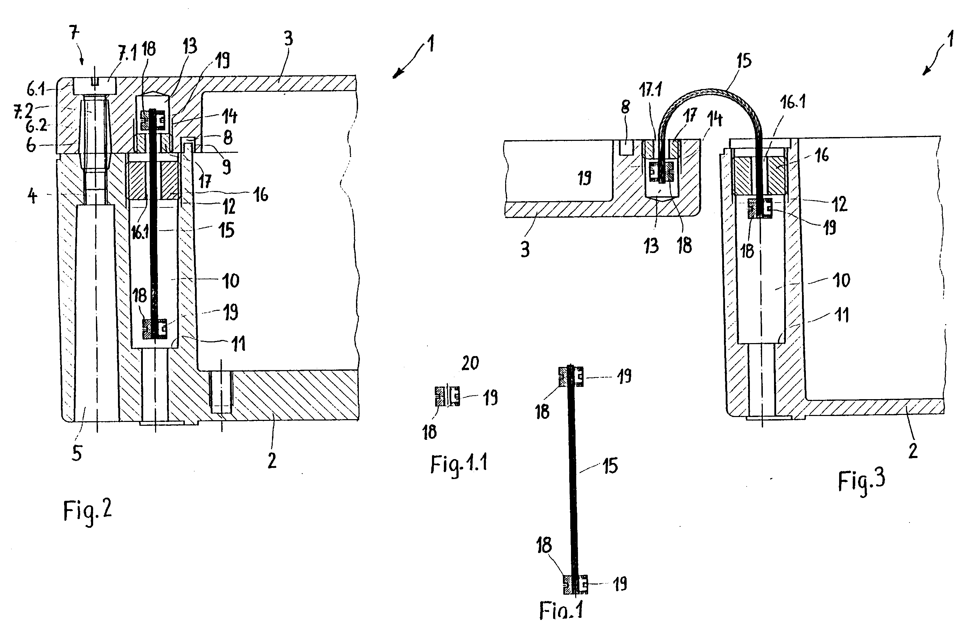

Bei dem in den Fig. 2 und 3 teilweise gezeigten Gehäuse 1 handelt es sich um ein Gehäuse mit rechteckigem oder quadratischem Grundriß. Dieses Gehäuse 1 besteht aus einem Gehäuse-Unterteil 2, welches nach unten geschlossen und nach oben offen ist, sowie einem Deckel 3 zum Schließen des Gehäuse-Unterteils 2. In jeder der vier Ecken des Gehäuse-Unterteils 2 ist eine Gewindebohrung 4 vorgesehen, die sich nach unten hin zu einem Kanal 5 erweitert, der bis zur Unterseite des Gehäuse-Unterteils 2 durchgeht. Diese Gewindebohrungen 4 dienen der Verschraubung des Deckels 3 mit dem Gehäuse-Unterteil 2. Dazu sind im Deckel 3 abgestufte Durchgangsbohrungen 6 vorgesehen, die einen oberen Senkbereich 6.1 für die Aufnahme des Schraubenkopfes 7.1 einer Deckelschraube 7 und einen sich daran anschließenden Bohrungsbereich 6.2 aufweisen, der bei verschraubtem Deckel mit etwas radialem Spiel vom Schraubenschaft 7.2 durchsetzt wird. Wenn alle vier Deckelschrauben 7 angezogen sind, sitzt der Deckel 3 fest auf dem Gehäuse-Unterteil 2. Eine im Deckel 3 umlaufende Nut 8 mit eingelegter Dichtung und eine in die Nut 8 eingreifende, am Gehäuse-Unterteil 2 umlaufende Leiste 9 sorgen dabei für einen dichten Sitz.

In jeder Ecke des Gehäuse-Unterteils 2 verläuft neben dem Kanal 5 und parallel zu diesem ein Befestigungskanal 10, der in seinem oberen Bereich einen größeren Durchmesser besitzt als in seinem unteren Bereich, wodurch eine Schulter 11 gebildet ist, die ein Widerlager für den Kopf einer nicht dargestellten Befestigungsschraube bildet, mit der das Gehäuse-Unterteil 2 z.B. an eine Wand angeschraubt werden kann. Im oberen Bereich sind die Befestigungskanäle 10 mit einem Gewinde 12 versehen. Koaxial mit diesen Gewinden 12 sind im Deckel 3 Sackbohrungen 13 vorgesehen, die zumindest an ihrem zum Unterteil hin mündenden Enden ebenfalls mit einem Gewinde 14 versehen sind. Die Gewinde 13, 14 dienen der Montage eines Drahtseil-Scharniers, welches aus einem Drahtseilstück 15 (siehe Fig. 1), zwei Gewindebuchsen 16, 17 sowie zwei Klemmstücken 18 besteht. Der Zusammenbau dieses Drahtseil-Scharniers sowie seine Montage mit dem Gehäuse 1 wird nachstehend beschrieben.

Zunächst wird auf ein Ende des Drahtseilstücks 15 ein Klemmstück 18 aufgeschoben, das eine entsprechende Durchgangsbohrung 20 besitzt. Anschließend wird eine zum Klemmstück 18 gehörende Madenschraube 19 angezogen, so daß das Klemmstück 18 fest auf dem Drahtseilstück 15 sitzt. Danach werden die beiden Gewindebuchsen 16, 17 auf das Drahtseilstück 15 aufgeschoben. Sie sind dazu mit Durchgangsbohrungen 16.1 bzw. 17.1 versehen. Mit dem Befestigen des zweiten Klemmstücks 18 am anderen Ende des Drahtseilstücks 15 ist der Zusammenbau des Drahtseil-Scharniers abgeschlossen. Die Gewindebuchsen 16, 17 sitzen nun unverlierbar auf dem Drahtseilstück 15.

Nun erfolgt die Montage des Drahtseil-Scharniers mit dem Gehäuse 1, die durch einfaches Einschrauben der Gewindebuchsen 16, 17 in die Gewinde 12 der Befestigungskanäle 10 bzw. in die Gewinde 14 der Sacklöcher 13 im Deckel 3 auf der gewünschten Gehäuseseite erfolgt. Zur Erleichterung des Einschraubens sind die Gewindebuchsen 16, 17 auf ihren einander zugewandten Stirnseiten mit Schlitzen (nicht dargestellt) für einen Schraubendreher versehen. Die Gewindebuchsen 16, 17 werden so weit eingeschraubt, daß sie zumindest mit den Schließflächen von Deckel 3 und Gehäuse-Unterteil 2 bündig abschließen.

Nun kann das Gehäuse-Unterteil 2 geschlossen werden. Dazu wird der Deckel 3 aufgelegt, und die Deckelschrauben 7 werden angezogen. Die Drahtseilstücke 15 hängen dabei mit einem ihrer Klemmstücke 18 in die Befestigungskanäle 10, wo sie nicht stören, da die Kanäle eine dafür entsprechende Länge haben, wie aus Fig. 2 hervorgeht. Aus dieser Darstellung ist auch ersichtlich, daß die Sacklöcher 13 im Deckel 2 genügend tief sind, um das jeweilige Klemmstück 18 problemlos aufnehmen zu können.

An dieser Stelle sei bemerkt, daß trotz der Nutzung der Befestigungskanäle 10 für die Montage des Drahtseil-Scharniers deren ursprüngliche Funktion erhalten bleibt. Wenn ein Festschrauben des Gehäuse-Unterteils an einer Unterlage gewünscht ist, so muß dies nur vor dem Einschrauben der Gewindebuchsen 16 erfolgen.

Zum Öffnen des Deckels 3 werden zunächst die vier Deckelschrauben 7 aus den Gewindebohrungen 4 herausgeschraubt. Nun kann der Deckel 3 auf der Gehäuseseite, auf der die beiden Drahtseil-Scharniere installiert sind, nach außen geschwenkt werden. Dadurch werden die Drahtseilstücke 15 so weit aus den Befestigungskanälen 10 gezogen, bis die unteren Klemmstücke 18 in Anschlag mit den Gewindebuchsen 16 gelangen. Jetzt ist der maximale Schwenkwinkel des Deckels 3 gegenüber dem Gehäuse-Unterteil 2 erreicht. Diese Situation ist schematisch in Fig. 3 dargestellt. Der Deckel 3 hängt jetzt am Gehäuse-Unterteil 2. Eventuell zwischen dem Gehäuse-Unterteil 2 und dem Deckel 3 verlaufende Kabel sind zugentlastet.

Die vorliegende Erfindung besitzt noch einen weiteren, bisher noch nicht erwähnten Vorteil. Möchten die Gehäuseanwender den maximalen Öffnungswinkel des Deckels 3, aus welchen Gründen auch immer, verringern, so kann das einfach und problemlos durch Demontage der Drahtseil-Scharniere und entsprechendes Kürzen der Drahtseilstücke 15 realisiert werden. Die Bestellung kürzerer Drahtseil-Scharniere ist nicht erforderlich.

## Patentansprüche

1. Gehäuse, insbesondere für den Einbau elektrotechnischer und elektronischer Bauteile, bestehend aus einem Gehäuse-Unterteil und einem daran befestigbaren Deckel, wobei das Gehäuse-Unterteil wenigstens auf einer Seite mindestens zwei von seiner Schließfläche bis zu seinem Boden durchgehende Befestigungskanäle aufweist, und Deckel und Gehäuse-Unterteil über flexible Innenelemente scharnierartig miteinander verbunden sind, gekennzeichnet durch folgende Merkmale:
- im Deckel (3) sind sich zu den Befestigungskanälen (10) hin öffnende Gewinde-Sackbohrungen (13, 14) vorgesehen,
- die Befestigungskanäle (10) sind an ihren, dem Deckel (3) zugewandten Enden mit einem Gewinde (12) versehen,
- in die Gewinde-Sackbohrungen (13, 14) des Deckels (3) und in die Gewinde (12) der Befestigungskanäle (10) ist jeweils eine Gewindebuchse (17, 16) mit einem Längs-Durchgangsloch (17.1, 16.1) eingeschraubt,
- die Gewindebuchsen (16, 17) sind durch jeweils ein ihre Längs-Durchgangslöcher (16.1, 17.1) mit radialem Spiel durchsetzendes, flexibles Element (15), welches an seinen über die Gewindebuchsen (16, 17) überstehenden Enden Verdikkungen (18) aufweist, deren Abmessungen größer sind als die lichte Weite der Längs-Durchgangslöcher (16.1, 17.1), miteinander verbunden.

2. Gehäuse nach Anspruch 1, dadurch gekennzeichnet, daß zumindest eine der Verdickungen (18) an den Enden des flexiblen Elements (15) ein auf das flexible Element (15) aufschiebbares und an diesem festschraubbares Klemmstück ist.

3. Gehäuse nach Anspruch 1 oder Anspruch 2, dadurch gekennzeichnet, daß das flexible Element (15) ein Drahtseil ist.

4. Gehäuse nach Anspruch 1 oder Anpruch 2, dadurch gekennzeichnet, daß das flexible Element (15) ein Profil aus flexiblem Kunststoff ist.

5. Gehäuse nach Anspruch 4, dadurch gekennzeichnet, daß eine der Verdickungen (18) an das Profil aus flexiblem Kunststoff angespritzt ist.
